# EUROPÄISCHE PATENTSCHRIFT

(11) **EP 1 128 433 B1**
(45) Veröffentlichungstag und Bekanntmachung des Hinweises auf die Patenterteilung: **18.06.2008**
(21) Anmeldenummer: 01104042.5
(22) Anmeldetag: 20.02.2001
(51) Int. Cl.: H01L 23/48

(54) **Verfahren zum Verbinden von Substraten einer vertikal integrierten Schaltungsstruktur**
Method of connecting substrates of a vertically integrated circuit structure
Methode de connexion de substrats dans une structure verticale à circuits integrés

(30) Priorität: 23.02.2000 DE 10008386
(43) Veröffentlichungstag der Anmeldung: 29.08.2001
(73) Patentinhaber: Giesecke & Devrient GmbH, 81677 München (DE)
(72) Erfinder: Grassl, Thomas, Dr., 85354 Freising (DE)
(74) Vertreter: Klunker . Schmitt-Nilson . Hirsch

(56) Entgegenhaltungen:
- EP-A- 0 316 799
- DE-A- 4 433 845
- DE-C- 19 813 239
- US-A- 4 505 799
- US-A- 5 852 310

## Beschreibung

Die Erfindung betrifft ein Verfahren zum Verbinden einzelner Substrate zu einer vertikal integrierten Schaltungsstruktur sowie eine gemäß diesem Verfahren hergestellte integrierte Schaltungsstruktur.

Unter vertikal integrierbaren Schaltungen versteht man mittels Planartechnik hergestellte Halbleiterschaltungen, die in mehreren Ebenen vertikal übereinander angeordnet werden, wodurch dreidimensionale Schaltungen entstehen. Die einzelnen Bauelemente und Schaltungsbestandteile der verschiedenen Ebenen werden durch vertikale Kontakte elektrisch miteinander verbunden. Dadurch kann gegenüber zweidimensionalen Schaltungen, d.h. Schaltungen nur in einer Ebene, eine höhere Packungsdichte erreicht werden. Auch aus sicherheitsrelevanten Aspekten bietet die vertikale Integration Vorteile, da besonders sensible Schaltungsbestandteile in Ebenen oder Schichten angeordnet werden können, die auf beiden Seiten von mindestens einer weiteren Ebene oder Schicht mit aktiven Bauelementen umgeben werden.

Bei der Herstellung der dreidimensionalen Schaltungen weichen insbesondere die vertikalen Kontakte von bekannten Technologien ab, da die einzelnen vertikal integrierbaren Schaltungen in bekannter und gut beherrschbarer Planartechnik hergestellt werden. Zur Herstellung der vertikalen Kontakte sind mehrere Verfahren bekannt geworden. Eines dieser Verfahren basiert darauf, auf eine fertigprozessierte Bauelementeschicht polykristallines Silizium abzuscheiden und zu rekristallisieren. In der rekristallisierten Schicht können weitere Bauelemente gefertigt werden. Nachteil dieses Verfahrens ist, daß sich wegen der hohen Temperaturen bei der Rekristallisierung die Eigenschaften der bereits fertiggestellten aktiven Bauelemente der unteren Ebene verändern können. Weiterhin wird wegen der seriellen Prozessierung der vertikal integrierten Gesamtschaltung eine entsprechend verlängerte Durchlaufzeit für die Herstellung benötigt. Bei einem anderen bekannten Verfahren ist es vorgesehen, die einzelnen vertikal integrierbaren Schaltungen bzw. Ebenen von Schaltungen getrennt aus verschiedenen Substraten herzustellen. Die Substrate mit den einzelnen Schaltungsebenen werden gedünnt, mit Vorder- und Rückseitenkontakten versehen und mittels eines Bond-Verfahrens vertikal verbunden. Nachteil dieses Verfahren ist es, daß zur Herstellung der Vorder- und Rückseitenkontakte teilweise Materialien verwendet werden, die in bekannten Halbleiterfertigungsprozessen nicht ohne weiteres eingesetzt werden können.

Aus der deutschen Offenlegungsschrift DE 44 33 845 A1 ist ein Verfahren zur Herstellung einer dreidimensionalen integrierten Schaltung bekannt, bei dem zwei fertigprozessierte und mit Metallisierungsstrukturen versehene Substrate miteinander verbunden werden. Die gedünnten Wafer werden in einzelne Chips zerlegt und auf das untere Substrat aufgebracht, wobei vor dem Zusammenfügen der Substrate zumindest eines der Substrate einem Funktionstest unterzogen wird und fehlerhafte Chips ausgesondert werden. Es wird dabei jeweils die Metallisierungsstruktur des unteren Wafers mit der Bauelementeebene des oberen Wafers verbunden, so daß ein integrierter Schaltkreis mit zwei oder mehreren voneinander unabhängig hergestellten Chips entsteht.

Aus der deutschen Patentschrift DE 198 13 239 C1 ist ein Verdrahtungsverfahren zur Herstellung einer vertikal integrierten Schaltungsstruktur bekannt. Dieses Verfahren, welches mit CMOS-kompatiblen Standard-Halbleitertechnologien durchführbar ist, sieht vor, daß zunächst gemäß dem Stand der Technik die einzelnen Bauelementelagen in unterschiedlichen Substraten unabhängig voneinander prozessiert und nachfolgend zusammengefügt werden. Dazu werden auf der Vorderseite des Top-Substrats Via-Löcher geöffnet, die vorzugsweise alle vorhandenen Bauelementelagen durchdringen. Danach wird das Top-Substrat von der Rückseite her bis an die Via-Löcher gedünnt. Anschließend wird ein fertigprozessiertes Bottom-Substrat mit dem Top-Substrat verbunden und die Via-Löcher bis auf eine Metallisierungsebene des Bottom-Substrats verlängert sowie der Kontakt zwischen Top- und Bottom-Substrat hergestellt. Das vorgestellte Verfahren erreicht eine hohe Integrationsdichte, indem die Via-Löcher Strukturen der obersten Metallisierung, vorzugsweise auch alle im Top-Substrat vorhandenen Bauelementelagen und Metallisierungsebenen durchdringen.

Die bestehenden Verbindungskontakte gehen immer von einer ohm'schen Verbindung zwischen einer Metallisierungsebene des oberen Chips mit einer Metallisierungsebene des unteren Chips aus, wodurch zur Prozessierung eine Vielzahl von Prozeßschritten benötigt wird. Weiterhin muß durch die Verbindung der Metallisierungsebenen ein bestimmter Mindestabstand zwischen der vertikalen Verbindungsleitung und dem nächstliegenden aktiven Element (Transistor) eingehalten werden, der die optimale Flächennutzung des Chips beschränkt.

Aus der europäischen Offenlegungsschrift EP 0 316 799 A1 ist eine Halbleiterschaltungsanordnung bekannt, welche eine vertikal integrierte Schaltungsstruktur erzeugt, indem zwei oder mehr aufeinander angeordnet werden, wobei der erste Halbleiterschaltkreis eine Halbleiterschaltungsschicht mit ersten aktiven Elementen auf der Vorderseite des Halbleiterlayers enthält und auf der Rückseite eine Nut geformt ist, welche bis an wenigstens eine Elektrode des aktiven Elements heranreicht. In die Nut sind zur Kontaktierung mit dem weiteren Halbleiterschaltkreis Leiterbahnen angeordnet, welche die Oberseite des rückseitigen Substrats mit den aktiven Elementen verbindet.

Der Erfindung liegt deshalb die Aufgabe zugrunde, ohm'sche Verbindungen auf ein Minimum zu beschränken, die Anzahl der Prozeßschritte zur Verbindung zweier gedünnter Wafer zu verringern und die Flächenpackungsdichte zu erhöhen.

Diese Aufgabe wird durch die Merkmale des Anspruchs 1 bzw. des Anspruchs 4 gelöst.

Die Erfindung geht aus von einem Verfahren zum Verbinden von zwei Substraten einer vertikal integrierten Schaltungsstruktur, bei der die einzelnen Substrate aus wenigstens einer ersten Lage mit Schaltungsstrukturen und einer Metallisierungsebene bestehen, wobei die Substrate durch ein sich im oberen Substrat befindliches mit leitendem Material ausgefülltes Via-Loch, das an der dem unteren Substrat zugewandten Seite des oberen Substrats eine Anschlußfläche hat, und über eine an der dem oberen Substrat zugewandten Seite des unteren Substrats liegende Anschlußfläche, die mit der Anschlußfläche des oberen Substrats sich in elektrisch leitender Verbindung befindet, elektrisch verbunden werden, wobei das obere Substrat von seiner keine Schaltungsstrukturen und Metallisierungsebene aufweisenden Seite her gedünnt wird und das zur elektrischen Verbindung vorgesehene Via-Loch bis in die dotierte leitfähige Zone eines Source-, Drain- oder Gate-Gebiets geätzt wird, wobei an den Innenwänden des Via-Lochs eine Isolation aufgebracht wird, und wobei die Isolation am Ende des Via-Lochs im Source-, Drain- oder Gate-Gebiet entfernt wird.

Im Gegensatz zu den ICV's gemäß dem Stand der Technik, welche von einer Metallisierungsebene eines ersten Substrats (Top-Substrat) zu einer Metallisierungsebene des zweiten Substrats (Bottom-Substrat) geführt werden, verbinden die ICV's gemäß der Erfindung direkt die entsprechenden Anschlüsse eines aktiven Elements, beispielsweise eines Transistors, mit der zur Verbindung mit dem zweiten Substrat vorgesehenen Kontaktfläche. Auf diese Weise werden die Inter-Chip-Verbindungen sehr kurz gehalten und es erfolgt insbesondere keine ohm'sche Verbindung mit der Metallisierungsebene des Top-Substrats, so daß die Angreifbarkeit der Verbindungen erschwert wird, da eine Kontaktierung der Anschlußelemente durch alle darüberliegenden Metallisierungen sehr schwierig ist und im weiteren das aktive Element dabei mit hoher Wahrscheinlichkeit zerstört würde. Im weiteren vermindert sich die Anzahl der Arbeitsschritte für die Herstellung, da die ICV's nicht durch verschiedene Materialien geführt werden müssen. Ferner werden keine zusätzlichen Flächen für die ICV-Verbindungen benötigt, insbesondere müssen keine Abstandsregeln eingehalten werden, so daß die Flächenpackungsdichte gegenüber den bekannten Herstellungsverfahren erhöht werden kann.

Ein nicht beanspruchtes Verfahren sieht vor, das Dünnen des Substrats bis in die dotierten leitfähigen Zonen hinein durchzuführen, so daß die Inter-Chip-Verbindung sich im wesentlichen auf die Anschlußfläche, welche zur Kontaktierung mit dem Bottom-Substrat vorgesehen ist, reduziert.

Vorzugsweise werden überdies mehrere derartige Via-Löcher im oberen Substrat hergestellt und das untere Substrat weist mehrere Anschlußflächen auf, wobei jeweils die Anschlußflächen der Via-Löcher des oberen Substrats mit den Anschlußflächen der obersten Metallisierungsebene des unteren Substrats verbunden werden.

Vorzugsweise ist das ausgefüllte Via-Loch funktionaler Bestandteil der Schaltungsstruktur.

Die erfindungsgemäße vertikal integrierte Schaltungsstruktur zeichnet sich durch zwei Substrate aus, die jeweils aus wenigstens einer ersten Lage mit Schaltungsstrukturen und einer Metallisierungsebene bestehen, wobei die Substrate durch ein sich im oberen Substrat befindliches mit leitendem Material ausgefülltes Via-Loch, das an der dem unteren Substrat zugewandten Seite des oberen Substrats eine Anschlußfläche hat, und über eine an der dem oberen Substrat zugewandten Seite des unteren Substrats liegende Anschlußflächen, die mit der Anschlußfläche des oberen Substrats sich in elektrisch leitender Verbindung befindet, elektrisch verbunden sind, wobei das zur elektrischen Verbindung verwendete Via-Loch sich von der dem unteren Substrat zugewandten Seite des oberen, gedünnten Substrats bis in die dotierte leitfähige Zone eines Source-, Drain- oder Gate-Gebiets erstreckt, und wobei die Innenwände des Via-Lochs mit einer Isolationsschicht versehen sind, welche am Ende des Via-Lochs im Source-, Drain- oder Gate-Gebiet offen ist.

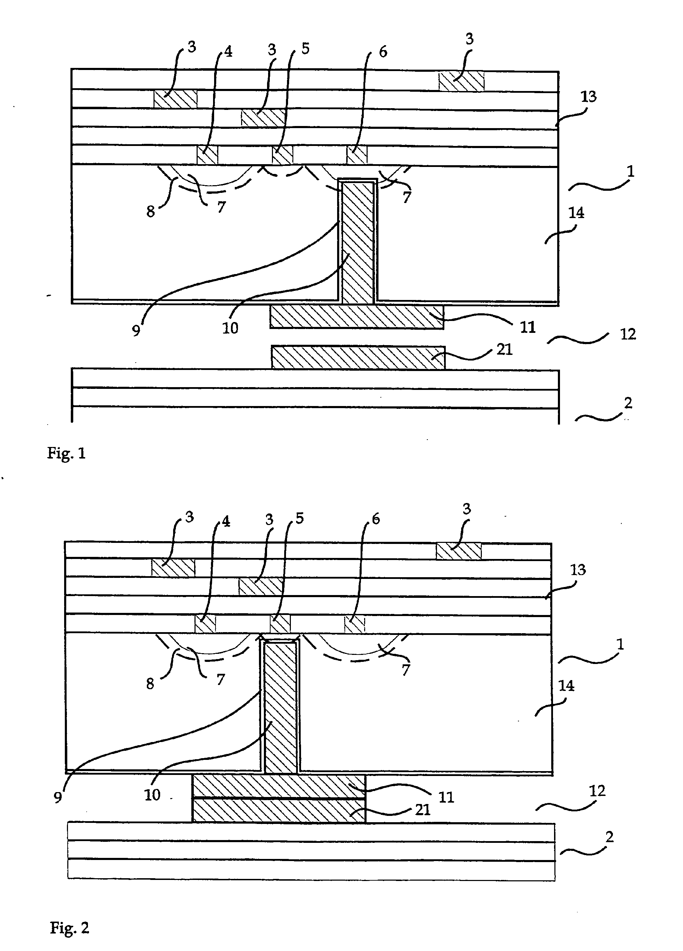

Im folgenden wird die Erfindung anhand der Fig. 1 und 2 näher erläutert. Es zeigen:
Fig. 1 eine vertikale integrierte Struktur mit einer Inter-Chip-Verbindung zum Drain-Anschluß des Substrats und
Fig. 2 eine Verbindung zum Gate-Anschluß des Top-Substrats.

Die Fig. 1 zeigt ein fertigprozessiertes Top-Substrat 1 sowie einen Teilbereich (Metallisierungsbereich) eines Bottom-Substrats 2. Das Top-Substrat 1 ist in einen ersten Teilbereich 13 mit der Metallisierungsstruktur und einen zweiten Teil 14 mit der Schaltungsstruktur aufgeteilt. Die Metallisierungsstruktur enthält die Metallbahnen 3 sowie die Transistoranschlüsse 4 (Source), 5 (Gate) und 6 (Drain), welche an das Silizium 14 angrenzend entsprechend der Transistorstruktur angeordnet sind. Bezugszeichen 7 gibt die Raumladungszone der jeweiligen Transistorbereiche an. Mit 8 ist die erweiterte Raumladungszone bezeichnet.

Im weiteren enthält das Top-Substrat 1 eine Inter-Chip-Verbindung 10, die mit leitendem Material ausgefüllt ist. Zur Isolierung gegenüber dem Silizium wird vor dem Befüllen mit leitendem Material das Via-Loch an den Innenwänden mit isolierendem Material beschichtet. Die Isolierung 9 ist bei einer Verbindungstechnik gemäß der Erfindung optional, da sich die Inter-Via-Verbindung nur im Silizium befindet. Bei der Verwendung eines SOI-Substrates (Silicon on insulator) kann zumindest im Bodenbereich des Top-Substrates eine separate Abscheidung von isolierendem Material entfallen. Ebenso kann der Drain-Anschluß 6 der Metallisierungsstruktur entfallen, da die ICV direkt im Raumladungsbereich 7, 8 mit dem Drain-Anschluß des Transistors verbunden ist. Das mit dem elektrisch leitenden Material gefüllte Inter-Via-Loch ist am unteren Ende des Top-Substrats mit einer Anschlußfläche 11 versehen, welche zur Verbindung mit dem Bottom-Substrat 2 dient. Hierzu ist eine Anschlußfläche 21 auf der der Anschlußfläche 11 gegenüberliegenden Seite des Bottom-Substrats 2 angeordnet. Das Top-Substrat 1 wird mit dem Bottom-Substrat 2 wie im Stand der Technik verbunden und es entsteht eine Bondfuge 12, die ggf. mit isolierendem Material aufgefüllt wird.

Die Fig. 2 zeigt den Aufbau einer vertikal integrierten Struktur, welche im wesentlichen der aus Fig. 1 entspricht und mit den gleichen Bezugszeichen versehen ist. Im Unterschied zur Fig. 1 sind in der Fig. 2 Top- und Bottom-Substrat über die Kontaktflächen 11 und 21 miteinander verbunden und die Inter-Chip-Verbindung ist zum Gate-Anschluß 5 eines Transistors geführt. Eine derartige Verbindung kann insbesondere dann vorgesehen werden, wenn der angesteuerte Transistor ein Schalter oder Verstärker ist bzw. der Transistor im Top-Substrat eine Treiberstufe ist. In diesem Fall kann auf eine zusätzliche Treiberstufe, wie sie ggf. nach dem Stand der Technik nötig ist, verzichtet werden.

Wie aus den Fig. 1 und 2 zu ersehen ist, befindet sich die Inter-Via-Verbindung 10 ausschließlich im Silizium 14. Dies hat zum einen den Vorteil, daß zur Erzeugung der Verbindung weniger Herstellungsschritte notwendig sind, da der Ätzvorgang nur auf ein einziges Material abgestimmt sein muß und zum anderen die Herstellung vereinfacht ist, da eine Verunreinigung der Nachbarbereiche durch Kupfer, wie sie beim Ätzen im Metallisierungsbereich leicht entstehen kann, nicht erfolgt.

## Patentansprüche

1. Verfahren zum Verbinden von zwei Substraten (1, 2) einer vertikal integrierten Schaltungsstruktur, bei der die einzelnen Substrate (1, 2) aus wenigstens einer ersten Lage mit Schaltungsstrukturen und einer Metallisierungsebene bestehen, wobei die Substrate durch ein sich im oberen Substrat (1) befindliches mit leitendem Material ausgefülltes Via-Loch (10), das an der dem unteren Substrat (2) zugewandten Seite des oberen Substrats (1) eine Anschlußfläche (11) hat, und über eine an der dem oberen Substrat (1) zugewandten Seite des unteren Substrats (2) liegende Anschlußfläche (21), die mit der Anschlußfläche (11) des oberen Substrats (1) sich in elektrisch leitender Verbindung befindet, elektrisch verbunden werden, wobei
das obere Substrat (1) von seiner keine Schaltungsstrukturen und Metallisierungsebene aufweisenden Seite her gedünnt wird und das zur elektrischen Verbindung vorgesehene Via-Loch (10) bis in die dotierte leitfähige Zone eines Source-, Drain- oder Gate-Gebiets (7, 8) geätzt wird, wobei
an den Innenwänden des Via-Lochs (10) eine Isolation aufgebracht wird, und wobei
die Isolation am Ende (7, 8) des Via-Lochs (10) im Source-, Drain- oder Gate-Gebiet entfernt wird.

2. Verfahren nach Anspruch 1, **dadurch gekennzeichnet, daß** mehrere derartige Via-Löcher im oberen Substrat hergestellt werden und, daß das untere Substrat mehrere Anschlußflächen aufweist, wobei jeweils die Anschlußflächen (11) der Via-Löcher (10) des oberen Substrats (1) mit den Anschlußflächen (21) der obersten Metallisierungsebene des unteren Substrats (2) verbunden werden.

3. Verfahren nach einem der Ansprüche 1 bis 2, **dadurch gekennzeichnet, daß** das ausgefüllte Via-Loch (10) funktionaler Bestandteil der Schaltungsstruktur ist.

4. Vertikal integrierte Schaltungsstruktur, bei der zwei Substrate (1, 2) jeweils aus wenigstens einer ersten Lage mit Schaltungsstrukturen und einer Metallisierungsebene bestehen, wobei die Substrate (1, 2) durch ein sich im oberen Substrat (1) befindliches mit leitendem Material ausgefülltes Via-Loch (10), das an der dem unteren Substrat (2) zugewandten Seite des oberen Substrats (1) eine Anschlußfläche (11) hat, und über eine an der dem oberen Substrat (1) zugewandten Seite des unteren Substrats (2) liegende Anschlußfläche (21), die mit der Anschlußfläche (11) des oberen Substrats (1) sich in elektrisch leitender Verbindung befindet, elektrisch verbunden sind, wobei das zur elektrischen Verbindung verwendete Via-Loch (10) sich von der dem unteren Substrat zugewandten Seite des oberen, gedünnten Substrats bis in die dotierte leitfähige Zone eines Source-, Drain- oder Gate-Gebiets (7, 8) erstreckt, und wobei die Innenwände des Via-Lochs (10) mit einer Isolationsschicht (9) versehen sind, welche am Ende des Via-Lochs im Source-, Drain- oder Gate-Gebiet (7, 8) offen ist.

## Claims

1. A method for connecting two substrates (1, 2) of a vertically integrated circuit structure wherein the individual substrates (1, 2) comprise at least a first layer with circuit structures and a metallization level, wherein the substrates are electrically connected by a via hole (10) located in the upper substrate (1) and filled in with conductive material, said hole having a terminal area (11) on the side of the upper substrate (1) facing the lower substrate (2), and via a terminal area (21) located on the side of the lower substrate (2) facing the upper substrate (1), said terminal area being in electroconductive connection with the terminal area (11) of the upper substrate (1), wherein
the upper substrate (1) is thinned from its side having no circuit structures and metallization level, and the via hole (10) provided for electric connection is etched up to the doped conductive zone of a source, drain or gate region (7, 8), wherein an insulation is applied to the inside walls of the via hole (10), and wherein the insulation is removed at the end (7, 8) of the via hole (10) in the source, drain or gate region.

2. The method according to claim 1, **characterized in that** a plurality of such via holes are produced in the upper substrate, and the lower substrate has a plurality of terminal areas, the terminal areas (11) of the via holes (10) of the upper substrate (1) being in each case connected to the terminal areas (21) of the uppermost metallization level of the lower substrate (2).

3. The method according to either of claims 1 to 2, **characterized in that** the filled-in via hole (10) is a functional component of the circuit structure.

4. A vertically integrated circuit structure wherein two substrates (1, 2) in each case consists of at least a first layer with circuit structures and a metallization level, wherein the substrates (1, 2) are electrically connected by a via hole (10) located in the upper substrate (1) and filled in with conductive material, said hole having a terminal area (11) on the side of the upper substrate (1) facing the lower substrate (2), and via a terminal area (21) located on the side of the lower substrate (2) facing the upper substrate (1), said terminal area (21) being in electroconductive connection with the terminal area (11) of the upper substrate (1), wherein the via hole (10) used for electric connection extends from the side of the upper, thinned substrate facing the lower substrate up to the doped conductive zone of a source, drain or gate region (7, 8), and wherein the inside walls of the via hole (10) are provided with an insulating layer (9) which is open at the end of the via hole in the source, drain or gate region (7, 8).

## Revendications

1. Procédé pour relier deux substrats (1, 2) d'une structure de circuit verticalement intégrée, où les différents substrats (1, 2) sont composés au moins d'une première couche avec des structures de circuit et d'un plan de métallisation, les substrats étant électriquement connectés par un trou d'interconnexion (10) disposé dans le substrat supérieur (1) et comblé de matériau conducteur, lequel présente une surface de connexion (11) sur la face du substrat supérieur (1) opposée au substrat inférieur (2), et par une surface de connexion (21) disposée sur une face du substrat inférieur (2) opposée au substrat supérieur (1), laquelle se trouve en liaison électrique conductrice avec la surface de connexion (11) du substrat supérieur (1), dans lequel
le substrat supérieur (1) est aminci depuis sa face ne comportant aucune structure de circuit et aucun plan de métallisation, et le trou d'interconnexion (10) prévu pour la liaison électrique chimiquement est attaqué jusque dans la partie conductrice dopée d'une zone de source, de drain ou de grille (7, 8),
une isolation est appliquée sur les parois intérieures du trou d'interconnexion (10), et
l'isolation est supprimée à l'extrémité (7, 8) du trou d'interconnexion (10) dans la zone de source, de drain ou de grille.

2. Procédé selon la revendication 1, **caractérisé en ce que** plusieurs trous d'interconnexion de ce type sont réalisés dans le substrat supérieur et **en ce que** le substrat inférieur présente plusieurs surfaces de connexion, les surfaces de connexion (11) des trous d'interconnexion (10) du substrat le plus élevé (1) étant respectivement reliées aux surfaces de connexion (21) du plan de métallisation supérieur du substrat inférieur (2).

3. Procédé selon l'une des revendications 1 ou 2, **caractérisé en ce que** le trou d'interconnexion (10) comblé est un composant fonctionnel de la structure de circuit.

4. Structure de circuit verticalement intégrée, où deux substrats (1, 2) sont composés chacun au moins d'une première couche avec des structures de circuit et d'un plan de métallisation, les substrats (1, 2) étant électriquement connectés par un trou d'interconnexion (10) disposé dans le substrat supérieur (1) et comblé de matériau conducteur, lequel présente une surface de connexion (11) sur la face du substrat supérieur (1) opposée au substrat inférieur (2), et par une surface de connexion (21) disposée sur une face du substrat inférieur (2) opposée au substrat supérieur (1), laquelle se trouve en liaison électrique conductrice avec la surface de connexion (11) du substrat supérieur (1), le trou d'interconnexion (10) utilisé pour la connexion électrique s'étendant de la face du substrat supérieur aminci opposée au substrat inférieur jusque dans la partie conductrice dopée d'une zone de source, de drain ou de grille (7, 8), et les parois intérieures du trou d'interconnexion (10) étant pourvues d'une couche d'isolation (9) ouverte à l'extrémité du trou d'interconnexion dans la zone de source, de drain ou de grille (7, 8).
